# EUROPEAN PATENT APPLICATION

(11) **EP 4 848 908 A1**
(43) Date of publication of application: **02.12.2026**
(21) Application number: 25745180.7
(22) Date of filing: 23.01.2025
(51) Int. Cl.: H05K 1/05, C08K 3/013, C08L 63/00, H05K 1/02, H05K 3/44

(54) **THERMALLY CONDUCTIVE SHEET**

(30) Priority: 25.01.2024 JP 2024009620
(71) Applicant: Denka Company Limited, Tokyo 103-8338 (JP)
(72) Inventor: MIYOSHI, Rio, Tokyo 103-8338 (JP); KUMAGAI, Ryota, Tokyo 103-8338 (JP); ICHIKAWA, Isamu, Tokyo 103-8338 (JP); NEBASHI, Ibuki, Tokyo 103-8338 (JP)
(74) Representative: Hoffmann Eitle
(86) International application number: PCT/JP2025/001980
(87) International publication number: WO 2025/159137

(57) **Abstract**

A thermally conductive sheet having: an epoxy resin A; and a thermally conductive filler, wherein the thermally conductive sheet has two or more peaks when heated from 23°C to 270°C at 10°C/min by a differential scanning calorimeter.

## Description

### Technical Field

The present invention relates to a thermally conductive sheet.

### Background Art

Various circuit boards have been put to practical use as circuit boards for mounting semiconductor elements and other electronic/electrical components to form hybrid integrated circuits. Circuit boards are classified, based on the board material, into resin circuit boards, ceramic circuit boards, metal-base circuit boards, and the like.

Resin circuit boards are inexpensive but have low thermal conductivity of the substrate, so their use is limited to applications utilizing relatively low power. Ceramic circuit boards are suited for applications utilizing relatively high power due to the characteristics of ceramics, namely high insulation reliability and heat resistance, but have the drawback of being expensive. Metal-base circuit boards, on the other hand, have properties intermediate between the two, and are suitable for general-purpose applications utilizing relatively high power, such as inverters for refrigerators, inverters for commercial air conditioners, power supplies for industrial robots, and power supplies for automobiles.

For example, Patent Document 1 discloses a laminate for a metal-base circuit board having a structure in which two metal layers are bonded by an insulating layer, addressing the problem of decreased adhesion reliability of the insulating layer during high-temperature processing, wherein the surface roughness of the metal layer bonded to the insulating layer is specified.

### Citation List

### Patent Literature

Patent Literature 1: Japanese Patent Laid-Open No.2022-173751

### Summary of the Invention

### Technical Problem

The insulating layer as described above can be formed by sandwiching a thermally conductive sheet between a metal plate and a metal layer and subjecting them to press-heating. The thermally conductive sheet is required to have excellent handleability as a sheet and to have the property of further curing by press-heating, and is therefore desirably a so-called B-stage thermally conductive sheet.

A B-stage thermally conductive sheet can be produced by forming an A-stage thermally conductive composition into a sheet form and partially curing it. However, control of this partial curing reaction is not easy; the curing reaction may be insufficient or may proceed excessively, leading to product lot quality variations. If the curing reaction is insufficient, the sheet cannot be handled as a sheet, and if the curing reaction has proceeded excessively, the adhesiveness between the metal plate and the metal layer is poor.

The present invention has been made in view of the above problems, and an object thereof is to provide an insulating thermally conductive sheet having a controlled curing reaction.

### Solution to Problem

The present inventors have conducted intensive studies to solve the above problems. As a result, they found that using a predetermined epoxy resin can solve the above problems, and thus completed the present invention.

That is, the present invention is as follows.
[1] A thermally conductive sheet comprising:
   epoxy resin A; and
   a thermally conductive filler,
   wherein the thermally conductive sheet has two or more peaks when heated from 23°C to 270°C at 10°C/min by a differential scanning calorimeter.
[2] The thermally conductive sheet according to [1], wherein, when, among the two or more peaks, a peak with lowest peak temperature is defined as a first peak and a peak with next lowest peak temperature is defined as a second peak,
   the peak-top heat flow W1 of the first peak is smaller than the peak-top heat flow W2 of the second peak.
[3] The thermally conductive sheet according to [1] or [2], wherein, when, among the two or more peaks, a peak with lowest peak temperature is defined as a first peak and a peak with next lowest peak temperature is defined as a second peak,
   the temperature T1 of the first peak is 75°C or more and less than 145°C.
[4] The thermally conductive sheet according to any one of [1] to [3], wherein, among the two or more peaks, a peak with lowest peak temperature is defined as a first peak and a peak with next lowest peak temperature is defined as a second peak,
   the temperature T2 of the second peak is more than 145°C and 200°C or less.
[5] The thermally conductive sheet according to any one of [1] to [4], wherein, among the two or more peaks, a peak with lowest peak temperature is defined as a first peak and a peak with next lowest peak temperature is defined as a second peak,
   the difference |T2 - T1| between the temperature T1 of the first peak and the temperature T2 of the second peak is 3°C or more and 50°C or less.
[6] The thermally conductive sheet according to any one of [1] to [5], wherein the epoxy equivalent weight of the epoxy resin A is 136 g/eq or more and 183 g/eq or less.
[7] The thermally conductive sheet according to any one of [1] to [6], further comprising a curing agent.
[8] The thermally conductive sheet according to any one of [1] to [7], wherein the thermally conductive filler comprises a boron nitride aggregate.
[9] A laminate comprising:
   a first metal layer;
   an insulating layer disposed on the first metal layer; and
   a second metal layer disposed on the insulating layer,
   wherein the insulating layer comprises the thermally conductive sheet according to any one of [1] to [8].
[10] A method for producing a laminate, the method comprising:
   a step of preparing the thermally conductive sheet according to any one of [1] to [8]; and
   a step of obtaining a laminate by press-heating the thermally conductive sheet while sandwiching it between a metal foil and a metal substrate.
[11] A circuit board comprising:
   a first metal layer;
   an insulating layer disposed on the first metal layer; and
   a second metal layer disposed on the insulating layer,
   wherein the insulating layer comprises the thermally conductive sheet according to any one of [1] to [8], and the second metal layer is a circuit part.
[12] A method for producing a circuit board, the method comprising:
   a step of preparing the laminate according to [9]; and
   a step of forming a circuit part by removing a portion of the first metal layer or a portion of the second metal layer of the laminate.

### Advantageous Effect of Invention

According to the present invention, an insulating thermally conductive sheet having a controlled curing reaction can be provided.

### Brief Description of Drawings

[FIG. 1] A cross-sectional view showing the laminate for a metal-base circuit board of the present embodiment.
[FIG. 2] A cross-sectional view showing the laminate for a metal-core circuit board of the present embodiment.
[FIG. 3] A cross-sectional view showing the circuit board of the present embodiment.
[FIG. 4] An example of a DSC curve of the thermally conductive sheet of the present embodiment.

### Description of Embodiment

Hereinafter, embodiments of the present invention (hereinafter referred to as "the present embodiment") will be described in detail, but the present invention is not limited thereto, and various modifications are possible without departing from the gist thereof. Numerical ranges expressed by the symbol "to" include the numerical values placed before and after "to." For example, the numerical range expressed as "20 to 80%" is the same as the numerical range expressed as "20% or more and 80% or less."

### 1. Thermally Conductive Sheet

The thermally conductive sheet of the present embodiment comprises epoxy resin A and a thermally conductive filler, and has two or more peaks when heated from 23°C to 270°C at 10°C/min by a differential scanning calorimeter (hereinafter also referred to as "DSC"). The thermally conductive sheet of the present embodiment may optionally contain a curing agent, a curing accelerator, an ion trapping agent, a solvent, and a surfactant. Hereinafter, the DSC peaks and each component will be described in detail.

The thermally conductive sheet of the present embodiment is preferably in the B-stage. This allows the thermally conductive sheet to have excellent handleability as a sheet, and to further cure upon press-heating while being sandwiched between a metal plate and a metal layer, thereby becoming an insulating layer having thermal conductivity and heat resistance.

In the present embodiment, the term "B-stage" refers, in accordance with JIS K6900:1994, to an intermediate stage in the reaction of certain thermosetting resins in which the material swells when in contact with certain liquids and softens when heated, but does not completely dissolve or melt. In contrast to B-stage, the term "A-stage" refers to an early stage in the preparation of certain thermosetting resins in which the material is still soluble in certain liquids and is fusible. Furthermore, "C-stage" refers to the final stage in the reaction of certain thermosetting resins in which the material becomes practically insoluble and infusible. The resin of a fully cured thermoset molded article is in the C-stage.

That the thermally conductive sheet is in the B-stage can also be evaluated by the degree of cure of the thermally conductive sheet. In the present embodiment, the B-stage refers to a degree of cure of the thermally conductive sheet of preferably 20 to 80%, 30 to 70%, or 40 to 60%. The degree of cure is a value representing the amount of heat generated until reaching the semi-cured (B-stage) state, with the total heat generated when going from an uncured state to a fully cured state being taken as 100%. The degree of cure can be determined using a thermal analyzer such as a differential scanning calorimeter.

### 1.1. DSC

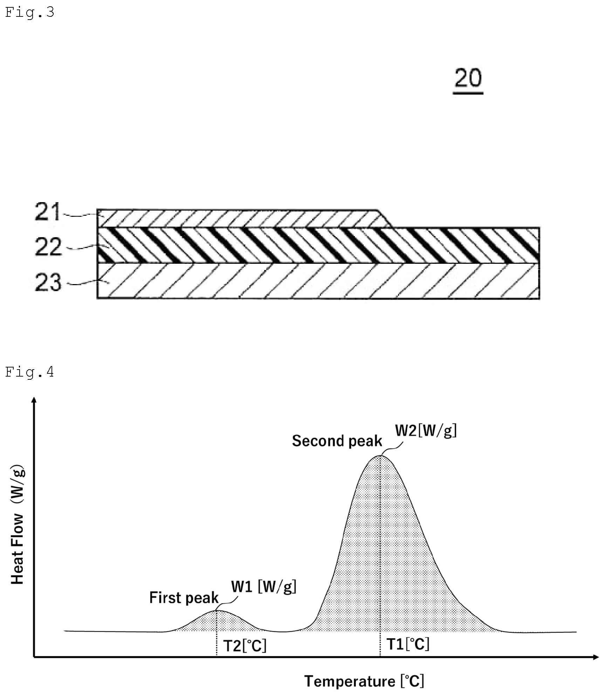

FIG. 4 shows an example of a DSC curve of the thermally conductive sheet of the present embodiment. The DSC curve shown in FIG. 4 shows the change in heat flow when heated from 23°C to 270°C at 10°C/min. As shown in FIG. 4, the thermally conductive sheet of the present embodiment has two or more peaks when heated from 23°C to 270°C at 10°C/min by DSC. The peaks may be endothermic peaks due to endothermic reactions, or exothermic peaks due to exothermic reactions. Among these, exothermic peaks due to exothermic reactions are preferred.

The temperature rise "from 23°C to 270°C" is a condition assuming heating from room temperature to a temperature (270°C) sufficient for the curing reaction to proceed in order to bring the B-stage thermally conductive sheet to the C-stage. Therefore, the peaks observed by DSC during the temperature rise from 23°C to 270°C include endothermic or exothermic peaks in the curing reaction when the thermally conductive sheet transitions from B-stage to C-stage.

Therefore, "having two or more peaks" defines the property that the thermally conductive sheet of the present embodiment can undergo at least two stages of curing reactions in at least different temperature ranges. The fact that at least two stages of curing reactions can occur in different temperature ranges means that, for example, even if the curing reaction of the A-stage thermally conductive composition proceeds excessively and all curing reactions on the low-temperature side proceed completely, the curing reaction on the high-temperature side can be kept from proceeding. Therefore, it is possible to avoid poor adhesiveness between the metal plate and the metal layer due to excessive progression of the curing reaction. At the same time, since proceeding the curing reaction on the low-temperature side sufficiently does not cause a problem of decreased adhesiveness, it is also possible to avoid a decrease in handleability as a sheet due to insufficient curing reaction on the low-temperature side.

In the present embodiment, it is also desirable that the curing reaction on the low-temperature side has not completely proceeded and is maintained in a state in which the curing reaction on the low-temperature side can further proceed, i.e., in a state of "having two or more peaks." This tends to further improve the adhesiveness between the metal plate and the metal layer.

In the present embodiment, "peak" refers to a maximum or minimum value, and a shape in the DSC curve that does not have a maximum or minimum value, such as a shoulder peak, does not correspond to a peak in the present embodiment.

Hereinafter, among the two or more peaks, the peak with the lowest peak temperature is defined as the first peak and the peak with the next lowest peak temperature is defined as the second peak. The number of peaks of the thermally conductive sheet of the present embodiment in the range of 23°C to 270°C is not particularly limited as long as it is two or more, but is preferably two.

The peak-top heat flow W1 of the first peak may be larger than the peak-top heat flow W2 of the second peak, or the peak-top heat flow W1 of the first peak may be smaller than the peak-top heat flow W2 of the second peak. Among these, the peak-top heat flow W1 of the first peak is preferably smaller than the peak-top heat flow W2 of the second peak. That is, it is preferred that the peak on the high-temperature side is large and the peak on the low-temperature side is small. This tends to further improve the peel strength.

When the peak-top heat flow W1 of the first peak is smaller than the peak-top heat flow W2 of the second peak, the peak-top heat flow W1 of the first peak is preferably 0.010 to 0.100, 0.015 to 0.085, 0.020 to 0.070, or 0.025 to 0.055. Also, when the peak-top heat flow W1 of the first peak is smaller than the peak-top heat flow W2 of the second peak, the peak-top heat flow W2 of the second peak is preferably 0.110 to 0.400, 0.120 to 0.350, 0.130 to 0.300, or 0.140 to 0.250.

Also, when the peak-top heat flow W1 of the first peak is larger than the peak-top heat flow W2 of the second peak, the peak-top heat flow W1 of the first peak is preferably 0.100 to 0.500, 0.110 to 0.450, or 0.120 to 0.400. Also, when the peak-top heat flow W1 of the first peak is smaller than the peak-top heat flow W2 of the second peak, the peak-top heat flow W2 of the second peak is preferably 0.010 to 0.090, 0.015 to 0.070, or 0.020 to 0.055.

The temperature T1 of the first peak is preferably 75°C or more and less than 145°C, 85°C or more and 143°C or less, 95°C or more and 140°C or less, or 105°C or more and 138°C or less. When the temperature T1 of the first peak is within the above range, reaction control by temperature adjustment in the B-stage formation step tends to become easier and the reaction on the high-temperature side tends to be less likely to proceed.

The temperature T2 of the second peak is preferably more than 145°C and 200°C or less, 148°C or more and 190°C or less, or 150°C or more and 180°C or less. When the temperature T2 of the second peak exceeds 145°C, the reaction on the high-temperature side tends to be less likely to proceed in the B-stage formation step. Also, when the temperature T2 of the second peak is 200°C or less, unreacted components tend to be less likely to remain in the C-stage formation step, and peel strength tends to improve further.

The difference |T2 - T1| between the temperature T1 of the first peak and the temperature T2 of the second peak is preferably 3°C or more and 50°C or less, 5°C or more and 45°C or less, or 10°C or more and 40°C or less. When the difference |T2 - T1| is within the above range, reaction control by temperature adjustment in the B-stage formation step tends to become easier and the reaction on the high-temperature side tends to be less likely to proceed.

The exothermic onset temperature of the first peak is preferably 90°C or more and 175°C or less, 95°C or more and 165°C or less, 100°C or more and 155°C or less, 105°C or more and 145°C or less, or 110°C or more and 135°C or less. When the exothermic onset temperature of the first peak is within the above range, reaction control by temperature adjustment in the B-stage formation step tends to become easier and the reaction on the high-temperature side tends to be less likely to proceed. The exothermic onset temperature can be determined as the temperature at the intersection of the tangent at the inflection point of the first peak with the DSC curve.

The total exothermic heat C1 (J/g) of the thermally conductive sheet of the present embodiment, determined from the DSC curve from 23°C to 270°C, is preferably 50 J/g or more and 170 J/g or less, 55 J/g or more and 160 J/g or less, 60 J/g or more and 150 J/g or less, or 65 J/g or more and 140 J/g or less. When the total exothermic heat C1 (J/g) is within the above range, reaction control by temperature adjustment in the B-stage formation step tends to become easier and the reaction on the high-temperature side tends to be less likely to proceed.

The method for achieving two or more peaks when heated from 23°C to 270°C at 10°C/min by DSC is not particularly limited, but examples include a method of adjusting the components of the thermally conductive sheet so that two different types of curing reactions can proceed: a reaction that proceeds at a relatively low temperature and a reaction that proceeds at a relatively high temperature.

Examples of such methods include a method in which the reaction of an epoxy resin and a curing agent proceeds on the low-temperature side to form an epoxy prepolymer, and the reaction between epoxy groups of the epoxy prepolymer proceeds on the high-temperature side. Furthermore, in controlling such reactions, a curing accelerator that promotes the reaction between the epoxy resin and the curing agent on the low-temperature side and a curing accelerator that promotes the reaction between the epoxy resins on the high-temperature side may be used.

The temperature T2 - T1 described above may be adjusted by controlling the reactions as described above, or may be adjusted by controlling the B-stage formation reaction.

### 1.2. Epoxy Resin A

The epoxy resin A is not particularly limited, and examples thereof include bisphenol A type epoxy resin, bisphenol AP type epoxy resin, bisphenol AF type epoxy resin, bisphenol B type epoxy resin, bisphenol BP type epoxy resin, bisphenol C type epoxy resin, bisphenol E type epoxy resin, bisphenol F type epoxy resin, bisphenol G type epoxy resin, bisphenol M type epoxy resin, bisphenol S type epoxy resin, bisphenol P type epoxy resin, bisphenol PH type epoxy resin, bisphenol TMC type epoxy resin, bisphenol Z type epoxy resin, polypropylene glycol type epoxy resin, polytetramethylene glycol type epoxy resin, naphthalene type epoxy resins such as 1,6-naphthalenediol type epoxy resin, anthracene type epoxy resins such as 9,10-anthracenediol type epoxy resin, phenylmethane type epoxy resin, tetrakisphenolmethane type epoxy resin, biphenyl type epoxy resin, epoxy resin having a triazine skeleton, and bisphenol A alkylene oxide adduct type epoxy resin.

The epoxy resin A may also contain a prepolymer of the above epoxy resin and a polyol. The polyol is not particularly limited, and examples thereof include aliphatic diols such as ethylene glycol, propanediol, butanediol, hexanediol, and decanediol; alicyclic diols such as cyclohexanediol; bisphenols such as bisphenol F, bisphenol A, bisphenol B, bisphenol AD, bisphenol S, and halogenated bisphenol A; and novolak resins having hydroxyl groups such as phenol novolak resin and bisphenol novolak resin.

The epoxy equivalent weight of epoxy resin A is preferably 120 to 200 g/eq, 125 to 195 g/eq, 130 to 190 g/eq, or 136 to 183 g/eq. When the epoxy equivalent weight a is within the above range, the glass transition temperature of the resulting cured product tends to improve further.

The content of epoxy resin A is preferably 15 to 60 parts by mass, 20 to 55 parts by mass, 25 to 50 parts by mass, or 30 to 45 parts by mass relative to 100 parts by mass of the resin component of the thermally conductive sheet. When the content of epoxy resin A is within the above range, the glass transition temperature of the resulting cured product tends to improve further.

In the present embodiment, the "resin component" refers to the amount of components excluding the thermally conductive filler and the solvent.

### 1.3. Thermally Conductive Filler

The thermally conductive filler is not particularly limited, and examples thereof include boron nitride, aluminum nitride, aluminum oxide, silicon nitride, silicon oxide, magnesium oxide, metallic aluminum, and zinc oxide.

Among these, boron nitride is preferred, and boron nitride aggregates are more preferred. Here, "boron nitride aggregate" refers to aggregate particles formed by the aggregation of primary particles of boron nitride. Using such a thermally conductive filler tends to further improve thermal conductivity and insulation reliability.

The average particle diameter of the thermally conductive filler is preferably 10 to 100 µm, 20 to 80 µm, 25 to 70 µm, or 30 to 60 µm. When the average particle diameter of the thermally conductive filler is 10 µm or more, high thermal conductivity tends to be achievable with a smaller amount. When the average particle diameter of the thermally conductive filler is 25 µm or more, insulation reliability and peel strength relative to the metal layer tend to improve further. When the average particle diameter of the thermally conductive filler is 100 µm or less, viscosity decreases and air bubble entrainment during sheet molding tends to decrease. Therefore, partial discharge due to air bubbles decreases, electric field concentration is less likely to occur, and insulation performance tends to improve further.

When the thermally conductive filler is an aggregate particle formed by aggregation of primary particles, the average particle diameter refers to the particle diameter of the aggregate particles. The particle diameter of aggregate particles is also referred to as the secondary particle diameter.

In the present embodiment, the average particle diameter of the thermally conductive filler refers to the particle diameter at the 50% cumulative value of the cumulative particle size distribution. The average particle diameter of the thermally conductive filler can be measured by the laser diffraction light scattering method. As a particle size distribution analyzer, for example, "MT3300EX" (manufactured by Nikkiso Co., Ltd.) can be used. For the measurement, water is used as the solvent and hexametaphosphoric acid as the dispersant, and as pretreatment, dispersion treatment was performed by applying an output of 20 W using a homogenizer for 30 seconds. A refractive index of 1.33 is used for water. When the measurement target is boron nitride powder, a refractive index of 1.80 can be used. The measurement time per measurement is not particularly limited, but is, for example, 30 seconds.

The content of the thermally conductive filler is preferably 25 to 55 vol%, 30 to 50 vol%, or 35 to 45 vol% based on the total amount of the thermally conductive sheet. When the content of the thermally conductive filler is 25 vol% or more, the thermal conductivity tends to improve further due to the action of the thermally conductive filler. When the content of the thermally conductive filler is 55 vol% or less, voids and the like are less likely to form, and thermal conductivity and insulation reliability tend to improve further.

### 1.4. Curing Agent

The thermally conductive sheet of the present embodiment may further contain a curing agent. The curing agent is not particularly limited, and examples thereof include phenolic curing agents, amine-based curing agents, acid anhydride curing agents, and thiol-based curing agents.

Phenolic curing agents are not particularly limited, and examples thereof include phenol novolak, xylylene novolak, and bisphenol A type novolak.

Amine-based curing agents are not particularly limited, and examples thereof include aromatic amine-based curing agents, aliphatic amine-based curing agents, and dicyandiamide.

Acid anhydride curing agents are not particularly limited, and examples thereof include aliphatic acid anhydrides such as phthalic anhydride derivatives, and aromatic acid anhydrides such as maleic anhydride.

Thiol-based curing agents are not particularly limited, and examples thereof include aliphatic polythioethers, aliphatic polythioesters, and aromatic-containing polythioethers.

The content of the curing agent is preferably 2.5 to 30 parts by mass, 5.0 to 25 parts by mass, 7.5 to 20 parts by mass, or 10 to 15 parts by mass based on 100 parts by mass of the resin component of the thermally conductive sheet. When the content of the curing agent is 2.5 parts by mass or more, the glass transition temperature and strength of the B-stage sheet tend to improve further. Also, when the amount of curing agent used is 30 parts by mass or less, embrittlement due to the B-stage sheet becoming excessively hard tends to be further suppressed.

### 1.5. Curing Accelerator

The thermally conductive sheet of the present embodiment may contain a curing accelerator for epoxy resin A. It should be noted that while the curing agent forms the main skeleton of the cured product, the curing accelerator does not form the main skeleton of the cured product but contributes to the curing rate and curing temperature.

Such curing accelerators are not particularly limited, and examples thereof include imidazole-based curing agents and phosphorus-based curing agents.

Imidazole-based curing agents are not particularly limited, and examples thereof include 2-methylimidazole, 2-ethylimidazole, 2-undecylimidazole, 2,4-dimethylimidazole, 2-heptadecylimidazole, 1,2-dimethylimidazole, 1,2-diethylimidazole, 2-phenyl-4-methylimidazole, 2,4,5-triphenylimidazole, 2-ethyl-4-methylimidazole, 2-phenylimidazole, 1-benzyl-2-phenylimidazole, 1-cyanoethyl-2-methylimidazole, 1-cyanoethyl-2-undecylimidazole, 1-benzyl-2-methylimidazole, 2-phenyl-4,5-dihydroxymethylimidazole, 2,3-dihydro-1H-pyrrolo[1,2-a]benzimidazole, 2-aryl-4,5-diphenylimidazole, 2,4-diamino-6-[2'-methylimidazolyl-(1')]-ethyl-S-triazine, 2,4-diamino-6-[2'-ethyl-4'-methylimidazolyl-(1')]-ethyl-S-triazine, 2,4-diamino-6-[2'-methylimidazolyl-(1')]-ethyl-S-triazine isocyanuric acid adduct, and 2-phenyl-4-methyl-5-hydroxymethylimidazole.

Phosphorus-based curing agents are not particularly limited, and examples thereof include tetraphenylphosphonium tetra-p-tolylborate, tetraphenylphosphonium tetraphenylborate, triphenylphosphine, tri-p-tolylphosphine, tris(4-chlorophenyl)phosphine, tris(2,6-dimethoxyphenyl)phosphine, triphenylphosphinetriphenylborane, tetraphenylphosphonium dicyanamide, and tetraphenylphosphonium tetra(4-methylphenyl)borate.

Among these, it is preferred to use a phosphorus-based curing agent and an imidazole-based compound in combination. This tends to further improve the curability and further improve the glass transition temperature of the resulting cured product.

The content of the phosphorus-based curing accelerator is preferably 0.01 to 2.5 parts by mass, 0.03 to 1.5 parts by mass, 0.05 to 0.80 parts by mass, or 0.10 to 0.60 parts by mass based on 100 parts by mass of the resin component of the thermally conductive sheet. When the content of the phosphorus-based curing accelerator is within the above range, the glass transition temperature and strength of the B-stage sheet tend to improve further.

The content of the imidazole-based curing accelerator is preferably 0.01 to 2.5 parts by mass, 0.03 to 1.5 parts by mass, 0.05 to 0.80 parts by mass, or 0.10 to 0.60 parts by mass based on 100 parts by mass of the resin component of the thermally conductive sheet. When the content of the imidazole-based curing accelerator is within the above range, embrittlement due to the B-stage sheet becoming excessively hard tends to be further suppressed.

The ratio of the content of the imidazole-based curing accelerator to the content of the phosphorus-based curing accelerator is preferably 0.50 to 2.00 parts by mass, 0.65 to 1.50 parts by mass, or 0.80 to 1.25 parts by mass. When the ratio of the content of the imidazole-based curing accelerator to the content of the phosphorus-based curing accelerator is within the above range, the glass transition temperature and strength of the B-stage sheet tend to improve further, and embrittlement due to the B-stage sheet becoming excessively hard tends to be further suppressed.

The total content of curing accelerators is preferably 0.03 to 4.5 parts by mass, 0.05 to 3.5 parts by mass, 0.10 to 2.5 parts by mass, or 0.15 to 1.5 parts by mass based on 100 parts by mass of the resin component of the thermally conductive sheet. When the total content of curing accelerators is 0.01 parts by mass or more, the glass transition temperature and strength of the B-stage sheet tend to improve further. Also, when the total content of curing accelerators is 4.5 parts by mass or less, embrittlement due to the B-stage sheet becoming excessively hard tends to be further suppressed.

### 1.6. Ion Trapping Agent

Ion trapping agents are not particularly limited, and examples thereof include conventionally known ion trapping agents such as hydrotalcite.

The amount of ion trapping agent used is preferably 0.01 to 3.5 parts by mass, 0.10 to 2.5 parts by mass, or 0.50 to 1.5 parts by mass based on 100 parts by mass of the resin component of the thermally conductive sheet.

### 1.7. Solvent

The composition prior to producing the thermally conductive sheet may contain a solvent. The solvent is not particularly limited, and examples thereof include alcohol-based solvents, glycol ether-based solvents, aromatic solvents, and ketone-based solvents. Examples of alcohol-based solvents include isopropyl alcohol and diacetone alcohol. Examples of glycol ether-based solvents include ethyl cellosolve and butyl cellosolve. Examples of aromatic solvents include toluene and xylene. Examples of ketone-based solvents include methyl ethyl ketone and methyl isobutyl ketone.

### 1.8. Surfactant

The surfactant is not particularly limited as long as it improves the dispersibility of the thermally conductive filler. Examples of the surfactant include copolymers having a (meth)acrylic monomer unit α having an anionic group, a (meth)acrylic monomer unit β having a cationic group, and a silicone (meth)acrylic monomer unit γ. Using such a surfactant tends to further improve the dispersibility of the thermally conductive filler.

The amount of surfactant used is preferably 0.01 to 10 parts by mass, 0.02 to 8 parts by mass, or 0.03 to 6 parts by mass based on 100 parts by mass of the resin component of the thermally conductive sheet. When the amount of surfactant used is within the above range, dispersibility tends to improve further.

### 2. Laminate

The laminate of the present embodiment comprises a first metal layer, an insulating layer disposed on the first metal layer, and a second metal layer disposed on the insulating layer, wherein the insulating layer comprises the above thermally conductive sheet. In this state, the thermally conductive sheet may have become C-stage through the press-heating during the laminate manufacturing process.

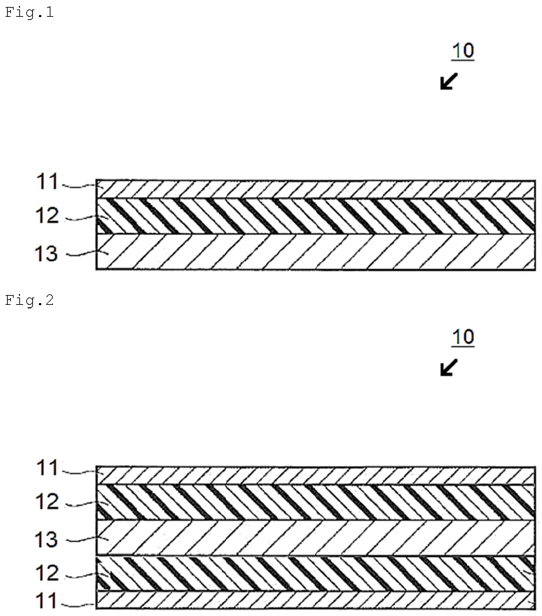

FIG. 1 shows a cross-sectional view of the laminate for a metal-base circuit board of the present embodiment. As shown in FIG. 1, in one aspect of the laminate 10 of the present embodiment, the thermally conductive sheet 12, which is the insulating layer, and the second metal layer 11 are provided in this order on one surface of the first metal layer 13 serving as the base.

FIG. 2 shows a cross-sectional view of the laminate for a metal-core circuit board of the present embodiment. As shown in FIG. 2, in another aspect of the laminate 10 of the present embodiment, the thermally conductive sheet 12, which is the insulating layer, and the second metal layer 11 are provided in this order on both surfaces of the first metal layer 13 serving as the core. Hereinafter, when the metal-base circuit board and the metal-core circuit board are not particularly distinguished, they are simply referred to as "circuit board."

In this way, by using the first metal layer 13 as the base or core, heat generated by electronic components constituting the second metal layer 11 can be conducted to the housing or heat sink via the thermally conductive sheet 12. The thermally conductive sheet used in such a laminate is required to have high insulation properties and high heat resistance.

The first metal layer serves as the base or core of the circuit board. The metal material constituting the first metal layer is not particularly limited, and examples thereof include aluminum, copper, iron, silver, gold, zinc, nickel, tin, and alloys containing these metals. Among these, aluminum, copper, and iron are preferred. By using such metal materials, heat dissipation can be improved and the coefficient of thermal expansion of the laminate can be further reduced.

The thickness of the first metal layer varies depending on whether it serves as the base or the core, but is preferably 0.01 to 10 mm, 0.1 to 5.0 mm, or 1.0 to 3.0 mm.

The second metal layer serves as the circuit part of the circuit board. The metal material constituting the second metal layer is not particularly limited, and may be, for example, aluminum, copper, iron, silver, gold, zinc, nickel, tin, or an alloy containing these metals.

The thickness of the second metal layer is preferably 0.01 to 5.0 mm, 0.02 to 3.0 mm, or 0.03 to 1.0 mm.

The insulating layer comprises the above thermally conductive sheet, and specifically may be one obtained by heating an A-stage or B-stage thermally conductive sheet to become C-stage.

The thickness of the insulating layer depends on the thickness of the thermally conductive sheet, but is preferably 30 to 500 µm, 50 to 300 µm, or 80 to 200 µm. When the thickness of the insulating layer is 30 µm or more, insulation reliability tends to improve further. Also, when the thickness of the insulating layer is 500 µm or less, thermal resistance tends to decrease further.

The method for producing the laminate of the present embodiment comprises a step of preparing the above thermally conductive sheet, and a step of obtaining a laminate by press-heating the thermally conductive sheet while sandwiching it between a metal foil and a metal substrate.

The time for press-heating is not particularly limited, but is, for example, 0.5 to 9 hours or 1 to 6 hours. The temperature for press-heating is not particularly limited, but is, for example, 70 to 250°C or 120 to 180°C. The pressure for press-heating is not particularly limited, but is, for example, 1 to 30 MPa, 5 to 25 MPa, or 8 to 20 MPa.

### 3. Circuit Board

The circuit board of the present embodiment is a printed circuit board using metal for the base or core, comprising a first metal layer, an insulating layer disposed on the first metal layer, and a second metal layer disposed on the insulating layer, wherein the insulating layer comprises the above thermally conductive sheet and the second metal layer is a circuit part.

FIG. 3 shows a cross-sectional view of the circuit board of the present embodiment. As shown in FIG. 3, the circuit board 20 of the present embodiment comprises an electrical circuit 21, a thermally conductive sheet 22, and a first metal layer 23, in this order. FIG. 3 shows a circuit board using a laminate for a metal-base circuit board, but the circuit board of the present embodiment is not limited thereto, and encompasses circuit boards using laminates for metal-core circuit boards.

The thermally conductive sheet 22 and the first metal layer 23 in FIG. 3 may be the same as the thermally conductive sheet 12 and the first metal layer 13 in FIGS. 1 and 2.

The method for producing the circuit board of the present embodiment comprises a step of preparing the above laminate, and a step of forming a circuit part by removing a portion of the first metal layer or a portion of the second metal layer of the laminate.

### Example

Hereinafter, the present invention will be described more specifically using Examples and Comparative Examples. The present invention is not limited in any way by the following examples.

### (Example 1)

30 parts by mass of bisphenol A type epoxy resin (manufactured by DIC Corporation, EXA850CRP, epoxy equivalent weight 170 to 175 g/eq, hereinafter also referred to as "Bis-A-Ep"), 12 parts by mass of bisphenol A type novolak resin (manufactured by DIC Corporation, VH4170, OH equivalent weight 118 g/eq, hereinafter also referred to as "Bis-A-Nv"), 0.2 parts by mass of triphenylphosphine, 0.2 parts by mass of 1-benzyl-2-phenylimidazole (1B2PZ), 40 parts by mass of diacetone alcohol (DAA), 2.3 parts by mass of surfactant (manufactured by Denka Company Limited, iSE-Z2), 1.2 parts by mass of ion trapping agent (iXEPLAS-B1), and boron nitride aggregate powder (BN aggregate powder (T40), average particle diameter 40 µm) in an amount of 40 vol% based on the total amount were mixed.

The resulting mixture was applied onto a polyethylene terephthalate (PET) film having a thickness of 0.038 mm so that the thickness after semi-curing would be 0.080 mm, and dried by heating at 100°C for 30 minutes to produce a thermally conductive sheet as a semi-cured product (B-stage). The degree of cure of the obtained thermally conductive sheet was 20%.

The obtained semi-cured product was peeled from the PET film and placed on a metal plate (copper plate with a thickness of 2.0 mm) serving as the first metal layer. Subsequently, a metal foil (copper foil with a thickness of 0.5 mm) serving as the second metal layer was placed on the semi-cured product, and then heated and cured at 180°C for 410 minutes while applying a surface pressure of 30 kgf/cm² (3 MPa) using a press, to obtain a laminate. The thickness of the insulating layer in the laminate was 80 µm.

Subsequently, a predetermined position on the metal foil (second metal layer) of the laminate was masked with an etching resist, and then the copper foil was etched using a mixed solution of sulfuric acid and hydrogen peroxide as the etchant. The etching resist was removed, and the laminate was washed and dried to obtain a metal-base circuit board having circular electrodes (copper foil) with a diameter of 20 mm.

### (Example 2)

A thermally conductive sheet was obtained by the same procedure as in Example 1, except that the bisphenol A type epoxy resin (Bis-A-Ep) in Example 1 was changed to 29 parts by mass of 1,6-naphthalenediol type epoxy resin (manufactured by DIC Corporation, product name HP-4032D, epoxy equivalent weight 136 to 148 g/eq, hereinafter also referred to as "Np-Ep"). The degree of cure of the obtained thermally conductive sheet was 20%. A laminate and a metal-base circuit board were also obtained using the obtained thermally conductive sheet.

### (Example 3)

A thermally conductive sheet was obtained by the same procedure as in Example 1, except that the bisphenol A type epoxy resin (Bis-A-Ep) in Example 1 was changed to 40 parts by mass of 1,6-naphthalenediol type epoxy resin (manufactured by DIC Corporation, product name HP-4032D, epoxy equivalent weight 136 to 148 g/eq, hereinafter also referred to as "Np-Ep") and the amount of bisphenol A type novolak (Bis-A-Nv) used was changed to 3 parts by mass. The degree of cure of the obtained thermally conductive sheet was 20%. A laminate and a metal-base circuit board were also obtained using the obtained thermally conductive sheet.

### (Comparative Example 1)

A thermally conductive sheet was obtained by the same procedure as in Example 1, except that the bisphenol A type novolak resin in Example 1 was changed to 10 parts by mass of aliphatic amine (manufactured by Huntsman Corporation, "D-400", amine equivalent weight 200) and triphenylphosphine (TPP) was not used. The degree of cure of the obtained thermally conductive sheet was 20%. A laminate and a metal-base circuit board were also obtained using the obtained thermally conductive sheet.

### [Differential Scanning Calorimeter (DSC)]

Using a differential scanning calorimeter (manufactured by TA Instruments, "Q2000"), the thermally conductive sheet after the above heat-drying was heated from 25 to 300°C at a temperature ramp rate of 10°C/min under a nitrogen atmosphere using the differential scanning calorimeter to obtain a DSC curve. From the obtained DSC curve, the number of peaks between 23°C and 270°C was counted, and the first peak on the low-temperature side and the second peak on the high-temperature side were identified to determine each peak temperature. The exothermic onset temperature was also calculated from the intersection of the tangent at the inflection point of the first peak on the low-temperature side with the baseline.

The total exothermic heat C1 (J/g) of the thermally conductive sheet after heat-drying was determined from the integral value of the area enclosed by the tangent, the baseline, and the DSC curve.

### [Degree of Cure]

Confirmation that the sample was a semi-cured product (B-stage) was performed by measuring the degree of cure using a differential scanning calorimeter (manufactured by TA Instruments, "Q2000"). Specifically, the thermally conductive sheet after the above heat-drying was heated from 25 to 300°C at a temperature ramp rate of 10°C/min under a nitrogen atmosphere using the differential scanning calorimeter, and the total exothermic heat C1 (J/g) was measured as described above. Next, using the thermally conductive sheet before the above heat-drying (solvent-evaporated product) as a sample, measurement was performed by the differential scanning calorimeter under the same conditions, and the total exothermic heat C0 (J/g) was measured. The degree of cure was then determined by the following formula. $Degree of cure = \left(C0-C1\right) / C 0 \times 100 \left(%\right)$

### [Insulation Reliability]

The insulation strength of the produced laminate was measured based on JIS C 6481 using TOS 8650 (manufactured by Kikusui Electronics Corp.).

### [Peel Strength]

A copper foil was cut from the produced laminate to a size of 10 mm × 100 mm, and the 90° peel strength between the copper foil and the thermally conductive sheet was measured under conditions of 23 ± 2°C and 50% relative humidity in accordance with the method specified in JIS C 6481. The measurement was repeated 5 times, and the arithmetic mean was taken as the peel strength.

### [Peel Strength Variation]

Peel strength was measured for four arbitrary samples produced by the same process as described above, and the deviation was obtained.

### [Thermal Conductivity]

Thermally conductive sheets were laminated and press-heated to produce a sample of 10 mm length × 10 mm width × 0.5 mm thickness, and the thermal diffusivity α was measured by the laser flash method. The thermal conductivity λ was evaluated from the following formula. $λ = α \times Cp \times ρ$

The specific heat capacity Cp was calculated from differential scanning calorimeter measurements. The specific gravity p of the sample was measured using a specific gravity measurement kit AD-1653 (trade name) manufactured by A&D Company, Limited by measuring the weight of the sample in air and the weight in distilled water at a temperature of 25°C and a pressure of 1013 hPa, and was calculated by the following formula. $ρ = A / \left(A-B\right) \times \left(ρ0-d\right) + d$ (wherein A is the mass of the sample in air, B is the mass of the sample in distilled water, ρ0 is the density of distilled water, and d is the density of air.)

**[Table 1]**

| | | Example | | | Comparative Example |
|---|---|---|---|---|---|
| | | 1 | 2 | 3 | 1 |
| Epoxy resin (Bis-A-Ep) | parts by mass | 30 | - | - | 30 |
| Epoxy resin (Np-Ep) | parts by mass | - | 29 | 40 | - |
| Epoxy resin (An-Ep) | parts by mass | - | - | - | - |
| Phenolic resin (Bis-A-Nv) | parts by mass | 12 | 12 | 3 | - |
| Aliphatic amine | parts by mass | - | - | - | 10 |
| Phosphorus-based curing accelerator (TPP) | parts by mass | 0.2 | 0.2 | 0.2 | - |
| Imidazole-based curing accelerator (1B2PZ) | parts by mass | 0.2 | 0.2 | 0.2 | 0.2 |
| Solvent (DAA) | parts by mass | 40 | 40 | 40 | 40 |
| In-house dispersing surfactant (iSE-Z2) | parts by mass | 2.3 | 2.3 | 2.3 | 2.3 |
| Ion trapping agent (iXEPLAS-B1) | parts by mass | 1.2 | 1.2 | 1.2 | 1.2 |
| BN aggregate powder (T40) | vol% | 40 | 40 | 40 | 40 |
| Number of peaks | | 2 | 2 | 2 | 2 |
| First peak - peak-top temperature | T1 [°C] | 141 | 133 | 138 | 154 |
| First peak - peak-top heat flow | W1 [W/g] | 0.35 | 0.14 | 0.038 | 0.14 |
| Second peak - peak-top temperature | T2 [°C] | 150 | 148 | 170 | - |
| Second peak - peak-top heat flow | W2 [W/g] | 0.038 | 0.020 | 0.183 | - |
| T2 - T1[°C] | | 9 | 15 | 32 | - |
| Exothermic onset temperature | °C | 118 | 112 | 113 | 95 |
| C₁ | J/g | 72 | 77 | 124 | 60 |
| Insulation reliability | [kV/mm] | 55 | 40 | 46 | 15 |
| Peel strength | [N/cm] | 9.4 | 8.0 | 7.5 | 10.0 |
| Peel strength variation | - | 0.5 | 0.5 | 0.5 | 3.0 |
| Thermal conductivity | [W/m·K] | 4.8 | 5.0 | 5.5 | 4.5 |

### Industrial Applicability

The thermally conductive sheet of the present invention has industrial applicability as a material constituting an insulating layer of a circuit board, and the like.

### Description of Reference Signs

10 ... laminate, 11 ... second metal layer, 12 ... thermally conductive sheet, 13 ... first metal layer, 20 ... circuit board, 21 ... electrical circuit, 22 ... thermally conductive sheet, 23 ... first metal layer

## Claims

1. A thermally conductive sheet comprising:
an epoxy resin A; and
a thermally conductive filler,
wherein the thermally conductive sheet has two or more peaks when heated from 23°C to 270°C at 10°C/min by a differential scanning calorimeter.

2. The thermally conductive sheet according to claim 1, wherein, when, among the two or more peaks, a peak with lowest peak temperature is defined as a first peak and a peak with next lowest peak temperature is defined as a second peak,
the peak-top heat flow W1 of the first peak is smaller than the peak-top heat flow W2 of the second peak.

3. The thermally conductive sheet according to claim 1, wherein, when, among the two or more peaks, a peak with lowest peak temperature is defined as a first peak and a peak with next lowest peak temperature is defined as a second peak,
the temperature T1 of the first peak is 75°C or more and less than 145°C.

4. The thermally conductive sheet according to claim 1, wherein, when, among the two or more peaks, a peak with lowest peak temperature is defined as a first peak and a peak with next lowest peak temperature is defined as a second peak,
the temperature T2 of the second peak is more than 145°C and 200°C or less.

5. The thermally conductive sheet according to claim 1, wherein, when, among the two or more peaks, a peak with lowest peak temperature is defined as a first peak and a peak with next lowest peak temperature is defined as a second peak,
the difference |T2 - T1| between the temperature T1 of the first peak and the temperature T2 of the second peak is 3°C or more and 50°C or less.

6. The thermally conductive sheet according to claim 1, wherein an epoxy equivalent weight of the epoxy resin A is 136 g/eq or more and 183 g/eq or less.

7. The thermally conductive sheet according to claim 1, further comprising a curing agent.

8. The thermally conductive sheet according to claim 1, wherein the thermally conductive filler comprises a boron nitride aggregate.

9. A laminate comprising:
a first metal layer;
an insulating layer disposed on the first metal layer; and
a second metal layer disposed on the insulating layer, wherein the insulating layer comprises the thermally conductive sheet according to any one of claims 1 to 8.

10. A method for producing a laminate, the method comprising:
a step of preparing the thermally conductive sheet according to any one of claims 1 to 8; and
a step of obtaining a laminate by press-heating the thermally conductive sheet while sandwiching it between a metal foil and a metal substrate.

11. A circuit board comprising:
a first metal layer;
an insulating layer disposed on the first metal layer; and
a second metal layer disposed on the insulating layer, wherein the insulating layer comprises the thermally conductive sheet according to any one of claims 1 to 8, and the second metal layer is a circuit part.

12. A method for producing a circuit board, the method comprising:
a step of preparing the laminate according to claim 9; and
a step of forming a circuit part by removing a portion of the first metal layer or a portion of the second metal layer of the laminate.
